# EUROPEAN PATENT APPLICATION

(11) **EP 2 980 169 A1**
(43) Date of publication of application: **03.02.2016**
(21) Application number: 14773247.3
(22) Date of filing: 10.03.2014
(51) Int. Cl.: C09D 5/24, C08J 7/04, C09D 5/00, C09D 7/12, C09D 201/00, H01B 1/00, H01B 1/22, H01B 13/00, H05K 1/09

(54) **COMPOSITION FOR FORMING CONDUCTIVE FILM, AND CONDUCTIVE FILM MANUFACTURING METHOD USING SAME**

(30) Priority: 29.03.2013 JP 2013073689
(71) Applicant: FUJIFILM Corporation, Tokyo 106-8620 (JP)
(72) Inventor: HAYATA Yuuichi, Ashigara-kami-gun Kanagawa 258-8577 (JP); KANO Takeyoshi, Ashigara-kami-gun Kanagawa 258-8577 (JP); WATANABE Toru, Ashigara-kami-gun Kanagawa 258-8577 (JP)
(74) Representative: Hoffmann Eitle
(86) International application number: PCT/JP2014/056208
(87) International publication number: WO 2014/156594

(57) **Abstract**

Provided is a composition for forming a conductive film, said composition containing: copper oxide particles (A) having an average particle size of 10-500 nm; copper particles (B) having an average particle size of 100-1000 nm; a polyol compound (C) which has two or more hydroxyl groups in the molecule; and at least one solvent (D) selected from the group consisting of water, and a water-soluble solvent. The ratio of the total mass (W_{A}) of the copper oxide particles (A) to the total mass (W_{B}) of the copper particles (B) is W_{A}:W_{B}=1:3-3:1, and the ratio of the sum total mass (W_{AB}) of the copper oxide particles (A) and the copper particles (B) to the total mass (W_{C}) of the polyol compound (C) is W_{AB}:W_{C}=20:1-2:1. The composition is capable of forming a conductive film which has high conductivity, and exhibits excellent adhesion to a substrate. Also provided is a conductive film manufacturing method using the composition.

## Description

### TECHNICAL FIELD

The invention relates to a conductive film-forming composition, particularly to a conductive film-forming composition containing predetermined copper oxide particles, predetermined copper particles and a predetermined polyol compound.

The invention also relates to a conductive film manufacturing method, particularly to a conductive film manufacturing method using the conductive film-forming composition mentioned above.

### BACKGROUND ART

As a method for forming a metal film on a substrate, a technique of forming an electrically conductive part such as a metal film or interconnects in a circuit board by applying a metal particle or metal oxide particle dispersion onto a substrate by a printing method, followed by thermal treatment for sintering is known.

The method above is considered promising in the field of next generation electronics development because the method is a simple, energy-saving and resource-saving method compared to conventional interconnect fabricating methods using a high temperature vacuum process (sputtering) or plating.

More specifically, in Patent Literature 1, a conductive metal paste comprising a metal filler and metal oxide super fine particles dispersed in a dispersant is described. The conductive metal paste for filling a via is characterized in that a polyhydric alcohol having not more than 10 carbons and a polyether compound are contained, the content ratio between the metal filler and the metal oxide super fine particles is from 10 to 1000 parts by weight of the metal filler based on 100 parts by weight of the metal oxide super fine particles, the average particle size of the metal filler is from 0.5 to 20 µm, the average particle size of the metal oxide super fine particles is not more than 200 nm, the metallic oxide is reduced to a metal composition by heating, and when the shear rate measured by a cone-plate type rotary viscometer is 10 s⁻¹, the viscosity at 25°C is not less than 50 Pa·s.

### CITATION LIST

### PATENT LITERATURE

Patent Literature 1: JP 4804083 B

### SUMMARY OF INVENTION

### TECHNICAL PROBLEMS

Meanwhile, electrical conductivity and adhesion to a substrate of a conductive film are required to achieve a higher level of performance in recent years.

When the present inventors examined the conductive metal paste described in Patent Literature 1, they found that there is room for further improvement in electrical conductivity and adhesion to a substrate.

In view of the above, an object of the invention is to provide a conductive film-forming composition which enables formation of a conductive film having high electrical conductivity and excellent adhesion to a substrate.

Another object of the invention is to provide a manufacturing method of a conductive film using the conductive film-forming composition.

### SOLUTION TO PROBLEMS

As a result of diligent research into the problems of the conventional art, the inventors found that the problems above can be solved by controlling a compositional ratio of ingredients.

Specifically, the inventors found that the objects can be achieved by a configuration described below.
(1) A conductive film-forming composition comprising:
   copper oxide particles (A) having an average particle size of from 10 to 500 nm; copper particles (B) having an average particle size of from 100 to 1000 nm; a polyol compound (C) having two or more hydroxy groups in a molecule thereof; and at least one kind of solvent (D) selected from the group consisting of water and a water-soluble solvent,
   wherein a ratio between a total weight W_{A} of the copper oxide particles (A) and a total weight W_{B} of the copper particles (B), W_{A}:W_{B}, is in a range from 1:3 to 3:1, and
   wherein a ratio between a total weight W_{AB} of the copper oxide particles (A) and the copper particles (B) and a total weight W_{C} of the polyol compound (C), W_{AB}:W_{C}, is in a range from 20:1 to 2:1.
(2) The conductive film-forming composition according to (1), wherein the average particle size of the copper particles (B) is not less than 200 nm but less than 500 nm.
(3) The conductive film-forming composition according to (1) or (2), wherein the ratio between the total weight W_{A} of the copper oxide particles (A) and the total weight W_{B} of the copper particles (B), W_{A}:W_{B}, is in a range from 1:2.5 to 2:1.
(4) The conductive film-forming composition according to any one of (1) to (3), wherein the ratio between the total weight W_{A} of the copper oxide particles (A) and the total weight W_{B} of the copper particles (B), W_{A}:W_{B}, is in a range from 1:2 to 1:1.
(5) The conductive film-forming composition according to any one of (1) to (4), further comprising a thixotropic agent (E).
(6) The conductive film-forming composition according to any one of (1) to (5), further comprising a thermoplastic resin (F).
(7) The conductive film-forming composition according to any one of (1) to (6), wherein the solvent (D) contains water.
(8) The conductive film-forming composition according to any one of (1) to (7), wherein the average particle size of the copper oxide particles (A) is from 50 to 300 nm.
(9) The conductive film-forming composition according to any one of (1) to (8), wherein the average particle size of the copper oxide particles (A) is from 80 to 180 nm.
(10) The conductive film-forming composition according to any one of (1) to (9), wherein the copper oxide particles (A) are copper oxide particles composed of copper (II) oxide.
(11) A conductive film manufacturing method, comprising:
   a coating film formation step of forming a coating film by applying the conductive film-forming composition described in any one of (1) to (10) on a substrate, and
   a conductive film formation step of forming a conductive film by heating and firing the coating film using heat or light as a heat source.
(12) The conductive film manufacturing method according to (11), further comprising a drying step of drying the coating film after the coating film formation step and before the conductive film formation step.
(13) The conductive film manufacturing method according to (11) or (12), wherein the substrate is a substrate made from polyimide resin or glass-epoxy resin.
(14) The conductive film manufacturing method according to any one of (11) to (13), wherein a thickness of the coating film is from 1 to 9 µm.

### ADVANTAGEOUS EFFECTS OF INVENTION

According to the invention, a conductive film-forming composition, from which a conductive film having high electrical conductivity (low electrical resistance) and excellent adhesion to a substrate, can be obtained.

### DESCRIPTION OF EMBODIMENTS

Preferable embodiments of a conductive film-forming composition and a conductive film manufacturing method of the invention are described below.

First, the advantages of the invention compared to the conventional art will be described in detail.

As described above, one of the features of the invention is that the ratio between the total weight W_{A} of copper oxide particles (A) and the total weight W_{B} of copper particles (B) (W_{A}:W_{B}) is set to be in a range from 1:3 to 3:1. Because metallic copper particles, which are formed by reduction of the copper oxide particles (A) during heating and firing, can facilitate fusion among the copper particles (B) in addition to fusion among themselves to form a conductor, when the ratio of W_{A}:W_{B} is in the range above, the compactness of metallic copper in a conductive film obtained is improved and electrical conductivity and adhesion to a substrate are good. However, when the ratio of W_{A}:W_{B} is outside the range above, fusion among the copper particles (B) is insufficient, the compactness of metallic copper in the conductive film obtained is decreased and particularly, the adhesion to a substrate deteriorates.

Another feature of the invention is that the ratio between the total weight W_{AB} of the copper oxide particles (A) and the copper particles (B) and the total weight W_{C} of a polyol compound (C) (W_{AB}:W_{C}) is set to be in a range from 20:1 to 2:1. The polyol compound (C) has the effect of improving dispersibility of the copper oxide particles (A) in the conductive film-forming composition and/or the effect of improving compactness of the whole conductive film including the copper particles since copper formed by reduction of copper oxide becomes compact due to high reducibility of the copper oxide. Therefore, when the ratio of W_{AB}:W_{C} is in the range above, film formability of the conductive film is improved and electrical conductivity and adhesion to a substrate are excellent. However, when W_{AB} is larger than 20:1, the reducing power of the copper oxide is not sufficient and electrical conductivity may be decreased or residual copper oxide may be present at the substrate interface, causing insufficient adhesion to a substrate. Also, when W_{AB} is smaller than 2:1, the distance between the copper particles or the copper particles formed by reduction of the copper oxide becomes larger, and compactness of the whole conductive film may be decreased or residues in the conductive film obtained may be increased, causing deterioration in electrical conductivity of the conductive film obtained and adhesion of the same to a substrate.

Hereinafter, the details of various ingredients (copper oxide particles (A), copper particles (B), polyol compound (C), solvent (D) and the like) of the conductive film-forming composition are described and the manufacturing method of the conductive film is described.

### <Copper oxide particles (A) with average particle size of 10 to 500 nm>

The conductive film-forming composition contains copper oxide particles (A) with an average particle size of 10 to 500 nm. The copper oxide particles (A) constitute metallic copper in the conductive film as a result of reduction of copper oxide to the metallic copper through thermal and firing treatment described below.

"Copper oxide" in the invention is a compound that substantially does not contain unoxidized copper. Specifically, the "copper oxide" refers to a compound that exhibits a peak derived from copper oxide and no peak derived from metallic copper in crystallographic analysis using X-ray diffraction. The expression "a compound substantially does not contain copper" means the copper content is not more than 1 wt% relative to the amount of the copper oxide particles.

As the copper oxide, copper(I) oxide and copper(II) oxide are preferable, and from the viewpoint of availability at low cost and low resistance, copper(II) oxide is more preferable. Namely, as the copper oxide particles (A), copper oxide particles made from copper(II) oxide or copper oxide particles made from copper(I) oxide are preferable, and copper oxide particles made from copper(II) oxide are more preferable.

The average particle size of the copper oxide particles (A) in the conductive film-forming composition is from 10 to 500 nm, preferably from 50 to 300 nm, and more preferably from 80 to 180 nm. When the average particle size is in this range, a conductive film obtained by using the conductive film-forming composition of the invention has excellent electrical conductivity and adhesion. For the copper oxide particles, commercially available copper oxide particle powders can be blended and mixed with stirring in preparation of the conductive film-forming composition, but it is preferable that a dispersion is prepared by a bead mill or the like, using copper oxide, a reductant and a solvent such as water, then mixed with other additives such as copper particles. In the invention, the average particle size of the copper oxide particles is the volume median diameter (Dv50), and can be measured by a particle size analyzer such as FPAR-1000 (manufactured by Otsuka Electronics Co., Ltd., dynamic light scattering type), for example.

The copper oxide particles (A) are not particularly limited, provided that the average particle size thereof in the conductive film-forming composition is in the range described above. For the copper oxide particles (A), either powder or a dispersion solution can be used, and specific examples include NanoTek CuO (C. I. Kasei Co., Ltd., average primary particle size: 50 nm) and the like. NanoTek CuO is commercially supplied as an aggregate, but the average particle size thereof can be adjusted to the range described above by treatments such as dispersing with beads and mixing with stirring.

### <Copper particles (B) with average particle size of 100 to 1000 nm>

The conductive film-forming composition includes copper particles (B) with an average particle size of 100 to 1000 nm. The copper particles (B) constitute metallic copper in the conductive film, together with metallic copper obtained by reduction of copper oxide through heating and firing treatment described below. By having the copper particles (B) together with the copper oxide particles (A), electrical conductivity of the conductive film formed becomes superior.

The average particle size of the copper particles (B) in the conductive film-forming composition is from 100 to 1000 nm, preferably not less than 200 nm but less than 500 nm, and more preferably from 200 to 480 nm. When the average particle size is in this range, a conductive film obtained has more excellent electrical conductivity and adhesion. In the invention, the average particle size of the copper particles is volume median diameter (Dv50), and can be measured by a particle size analyzer such as FPAR-1000 (manufactured by Otsuka Electronics Co., Ltd., dynamic light scattering type), for example.

Copper particles (B) are not particularly limited, provided that the average particle size thereof in the conductive film-forming composition is in the range described above. Because the copper particles have large primary particle size, it is possible to disperse to the primary particle size by dispersing with beads or mixing with stirring. For the copper particles (B), either powder or a dispersion liquid can be used, and specific examples include wet copper powder 1020Y (Mitsui Mining and Smelting Co., Ltd., average particle size: 360 nm), wet copper powder 1030Y (Mitsui Mining and Smelting Co., Ltd., average particle size: 480 nm), wet copper powder 1050Y (Mitsui Mining and Smelting Co., Ltd., average particle size: 750 nm), wet copper powder 1100Y (Mitsui Mining and Smelting Co., Ltd., average particle size: 1000 nm) and the like.

### <Polyol compound (C) having two or more hydroxy groups in the molecule>

The conductive film-forming composition includes a polyol compound (C) having two or more hydroxy groups in the molecule. The polyol compound (C) has the effect of improving dispersibility of the copper oxide particles (A) and/or the effect of improving compactness of the metallic copper in the conductive film obtained. By containing the polyol compound (C), film formability of the conductive film improves and electrical conductivity and adhesion of the conductive film obtained improve.

The polyol compound (C) is not particularly limited provided that it has two or more hydroxy groups in the molecule. Examples thereof include polyhydric alcohol having not more than 10 carbons and a polyether compound, and the like.

Examples of the polyhydric alcohol having not more than 10 carbons include diols such as ethylene glycol, diethylene glycol, 1,2-propanediol (propylene glycol), 1,3-propanediol, 1,2-butanediol, 1,3-butanediol, 1,4-butanediol, 2,3-butanediol, pentanediol, hexandiol, and octandiol, triols such as 1,2,3-propane triol (glycerin), and 1,2,4-butanetriol, sugar alcohol such as erythritol, pentaerythritol, D-threitol, L-threitol, D-arabinitol, L-arabinitol, xylitol, ribitol, D-iditol, galactitol, D-glucitol, mannitol, volemitol, perseitol, and D-erythro-D-galacto-octitol, and monosaccharides such as ribulose, xylulose, ribose, arabinose, xylose, lyxose, deoxyribose, psicose, fructose, sorbose, tagatose, allose, altrose, glucose, mannose, gulose, idose, galactose, talose, fucose, fuculose, rhamnose, and heptose sedoheptulose.

The polyether compound is preferably a linear-chain aliphatic polyether compound with a repeating unit thereof being an alkylene group having from 2 to 6 carbons. The linear-chain aliphatic polyether compound may be a polyether copolymer or a polyether block copolymer with two or more kinds of monomers.

Examples of the linear-chain polyether compound include, but not limited to, polyether homopolymers such as polyethyleneglycol, polypropyleneglycol and polybutyleneglycol, bipolymers such as ethylene glycol/propylene glycol, and ethylene glycol/butylene glycol, and linear-chain terpolymers such as ethylene glycol/propylene glycol/ethylene glycol, propylene glycol/ethylene glycol/propylene glycol, and ethylene glycol/butylene glycol/ethylene glycol. Examples of the block copolymer include polyether block copolymers which include diblock copolymers such as polyethyleneglycolpolypropyleneglycol, polyethyleneglycolpolybutyleneglycol, and linear-chain triblock copolymers such as polyethyleneglycolpolypropyleneglycolpolyethyleneglycol, polypropyleneglycolpolyethyleneglycolpolypropyleneglycol, and polyethyleneglycolpolybutyleneglycolpolyethyleneglycol.

The weight-average molecular weight of the linear-chain aliphatic polyether compound is not particularly limited, and is preferably from 150 to 1000, and more preferably from 150 to 600. If the weight-average molecular weight is in this range, film formability of the conductive film-forming composition is exceptionally good, while the conductive film-forming composition is easily decomposed and burned off after the reduction of the copper oxide particles (A). If the weight-average molecular weight is less than 150, film formability in formation of the conductive film tends to be decreased. If the weight-average molecular weight is greater than 1000, the volume resistance of the conductive film obtained tends to be high.

The both ends of the linear-chain aliphatic polyether compound are preferably hydroxy groups.

### <At least one kind of solvent (D) selected from the group consisting of water and water-soluble solvents>

The conductive film-forming composition includes at least one kind of solvent (D) selected from the group consisting of water and water-soluble solvents. The solvent (D) is not particularly limited provided that the solvent is selected from the group consisting of water and water-soluble solvents, can disperse, but does not react with, the copper oxide particles (A) and the copper particles (B) and can dissolve or disperse, but does not react with, the polyol compound (C).

For the water, water having purity at the level of ion-exchanged water is preferable.

The preferable water-soluble solvents include water soluble alcohol, alkyl ether derived from the water soluble alcohol, alkyl ester derived from the water soluble alcohol and a mixture thereof.

The preferable water soluble alcohol is aliphatic alcohol having from 1 to 3 hydroxy groups, and examples thereof specifically include methanol, ethanol, 1-propanol, 1-butanol, 1-pentanol, 1-hexanol, cyclohexanol, 1-heptanol, 1-octanol, 1-nonanol, 1-decanol, glycidol, methyl cyclohexanol, 2-methyl-1-butanol, 3-methyl-2-butanol, 4-methyl-2-pentanol, isopropyl alcohol, 2-ethyl butanol, 2-ethyl hexanol, 2-octanol, terpineol, dihydroterpineol, 2-methoxyethanol, 2-ethoxyethanol, 2-n-butoxyethanol, carbitol, ethylcarbitol, n-butylcarbitol, diacetone alcohol, ethylene glycol, diethylene glycol, triethylene glycol, tetraethylene glycol, propylene glycol, trimethylene glycol, dipropylene glycol, tripropylene glycol, 1,2-butylene glycol, 1,3-butylene glycol, 1,4-butylene glycol, pentamethylene glycol, hexylene glycol, glycerin and the like.

Among these examples, aliphatic alcohol having from 1 to 6 carbons and from 1 to 3 hydroxy groups is preferable due to having a boiling point not too high and a tendency not to remain as residue after the conductive film formation. Specifically, methanol, ethylene glycol, glycerin, 2-methoxyethanol, diethylene glycol, and isopropyl alcohol are preferable.

Examples of alkyl ether derived from water soluble alcohol include diethylether, diisobutylether, dibutylether, methyl-t-butylether, methylcyclohexylether, diethyleneglycoldimethylether, diethyleneglycoldiethylether, triethyleneglycoldimethylether, triethyleneglycoldiethylether, tetrahydrofuran, tetrahydropyran, 1,4-dioxane and the like.

Among these examples, alkyl ether having from 2 to 8 carbons derived from aliphatic alcohol having from 1 to 4 carbons and from 1 to 3 hydroxy groups is preferable. Specifically, diethylether, diethyleneglycoldimethylether and tetrahydrofuran are more preferable.

Examples of alkyl ester derived from water soluble alcohol include methyl formate, ethyl formate, butyl formate, methyl acetate, ethyl acetate, butyl acetate, methyl propionate, ethyl propionate, butyl propionate, γ-butyrolactone and the like.

Among these examples, alkyl ester having from 2 to 8 carbons derived from aliphatic alcohol having from 1 to 4 carbons and from 1 to 3 hydroxy groups is preferable. Specifically, methyl formate, ethyl formate and methyl acetate are more preferable.

Among the solvents described above, particularly the use of water and/or water soluble alcohol as a primary solvent is preferable because the boiling point thereof is not too high. The primary solvent is a solvent contained in the greatest amount in a solvent.

### <Thixotropic agent (E)>

The conductive film-forming composition may further include a thixotropic agent (E). The thixotropic agent (E) provides thixotropy to the conductive film-forming composition and prevents dripping before drying of the conductive film-forming composition having been either coated or printed on a substrate. Owing to this, contacts between fine patterns can be avoided.

The thixotropic agent (E) is not particularly limited provided that the thixotropic agent (E) is a known thixotropic agent (thixotropy imparting agent) used in the conductive film-forming composition including the solvent and does not induce adverse effects on adhesion and electrical conductivity of the conductive film obtained. The thixotropic agent (E) is preferably an organic thixotropic agent. Specific examples of the organic thixotropic agent include BYK-425 (urea-modified urethane urethane solution; BYK Japan KK), BYK-428 (solution of urethane having multiple sidechains; BYK Japan KK) and the like.

### <Thermoplastic resin (F)>

The conductive film-forming composition may include thermoplastic resin (F). For the thermoplastic resin (F), one kind of thermoplastic resin may be used alone, or two or more kinds of thermoplastic resin may be used in combination. The kind of thermoplastic resin (F) is not particularly limited, but thermoplastic resin that has two or more hydroxy groups in the molecule is excluded. Examples of the thermoplastic resin (F) include acrylic resin, polyester resin, polyolefin resin, polyurethane resin, polyamide resin, rosin blend and vinyl-based polymer.

Examples of the acrylic resin include polymethyl acrylate (PAM), polymethyl methacrylate (PMMA) and the like. Examples of the polyester resin include polyethylene terephthalate (PET), polytrimethylene terephthalate (PTT), polybutylene terephthalate (PBT), polyethylene naphthalate (PEN), polybutylene naphthalate (PBN) and the like. Examples of the polyolefin resin include polyethylene (PE), polypropylene (PP) and the like. Examples of the polyamide resin include nylon 6, nylon 11, nylon 12, nylon 66, nylon 610, nylon 6T, nylon 6I, nylon 9T, nylon M5T and the like. Examples of the vinyl-based polymer include polyvinylpyrrolidone (PVP), polyvinyl acetate (PVAc) and the like.

The weight average molecular weight of thermoplastic resin is not particularly limited, and is preferably from 10,000 to 250,000 and more preferably from 20,000 to 100,000, from the viewpoint of good adhesion and electrical conductivity of the conductive film. The weight average molecular weight of thermoplastic resin is measured by gel permeation chromatography (GPC).

### <Other ingredients>

The conductive film-forming composition may include ingredients other than the copper oxide particles (A), the copper particles (B), the polyol compound (C), the solvent (D), the thixotropic agent (E) and the thermoplastic resin (F) described above.

For example, the conductive film-forming composition may include a surfactant. The surfactant improves dispersibility of the copper oxide particles. The kind of the surfactant is not particularly limited, and examples thereof include anionic surfactants, cationic surfactants, nonionic surfactants, fluorosurfactants, amphoteric surfactants and the like. One kind of surfactant may be used alone or two or more kinds may be used in combination.

### [Conductive film-forming composition]

The conductive film-forming composition includes the copper oxide particles (A), the copper particles (B), the polyol compound (C), the solvent (D), optionally the thixotropic agent (E), optionally the thermoplastic resin (F), and optionally the other ingredients, as described above.

The contents of the copper oxide particles (A) and the copper particles (B) in the conductive film-forming composition are not particularly limited provided that the ratio between the total weight W_{A} of the copper oxide particles (A) and the total weight W_{B} of the copper particles (B) (W_{A}:W_{B}) is in the range from 1:3 to 3:1, and the ratio is preferably in the range from 1:2.5 to 2:1 and more preferably in the range from 1:2 to 1:1.

Because metallic copper particles, which are formed by reduction of the copper oxide particles (A) during heating and firing, can facilitate fusion among the copper particles (B) in addition to fusion among themselves to form a conductor, when the ratio of W_{A}:W_{B} is in the range above, the compactness of metallic copper in a conductive film obtained is improved and electrical conductivity and adhesion to a substrate are good. However, when the ratio of W_{A}:W_{B} is outside the range above, fusion among the copper particles (B) is not sufficient, the compactness of metallic copper in the conductive film obtained may be decreased and particularly, the adhesion to a substrate may deteriorate.

The polyol compound (C) content in the conductive film-forming composition is not particularly limited provided that the ratio between the total weight W_{AB} of the copper oxide particles (A) and the copper particles (B) and the total weight W_{C} of the polyol compound (C) (W_{AB}:W_{C}) is in the range from 20:1 to 2:1. The ratio is preferably in the range from 15:1 to 5:1, and more preferably in the range from 15:1 to 9:1.

The polyol compound (C) has the effect of improving dispersibility of the copper oxide particles (A) in the conductive film-forming composition and/or the effect of improving compactness of the whole conductive film including the copper particles since copper formed by reduction of copper oxide becomes compact due to high reducibility of the copper oxide. Therefore, when the ratio of W_{AB}:W_{C} is in the range above, film formability of the conductive film is improved and electrical conductivity and adhesion to a substrate are excellent. However, when W_{AB} is larger than 20:1, the reducing power of the copper oxide is not sufficient and electrical conductivity may be decreased or residual copper oxide may be present at the substrate interface, causing insufficient adhesion to a substrate. Also, when W_{AB} is smaller than 2:1, the distance between the copper particles or the copper particles formed by reduction of the copper oxide becomes larger, and compactness of the whole conductive film may be decreased or residues in the conductive film obtained may be increased, causing deterioration in electrical conductivity of the conductive film obtained and adhesion of the same to a substrate.

The solvent (D) content in the conductive film-forming composition is not particularly limited. In order to suppress the increase in viscosity of the conductive film-forming composition and to improve handleability, the solvent (D) content is preferably from 10 to 60 parts by weight and more preferably from 20 to 50 parts by weight, based on 100 parts by weight of the total ingredients in the composition except the solvent, from the viewpoint of printability and storage stability.

When the conductive film-forming composition includes the thixotropic agent (E), the thixotropic agent (E) content in the conductive film-forming composition is not particularly limited. In order to prevent dripping of a coating film before drying and not to cause any adverse effect on adhesion and electrical conductivity of the conductive film formed, the thixotropic agent (E) content in the conductive film-forming composition is preferably from 0.3 to 5 parts by weight, and more preferably from 1.0 to 3.0 parts by weight, based on 100 parts by weight of the total amount of the copper oxide particles (A) and the copper particles (B).

When the conductive film-forming composition includes the thermoplastic resin (F), the thermoplastic resin content in the conductive film-forming composition is not particularly limited. The thermoplastic resin content in the conductive film-forming composition is preferably not less than 2 parts by weight, more preferably from 2 to 30 parts by weight and even more preferably from 2 to 10 parts by weight, based on 100 parts by weight of the total amount of the copper oxide particles (A) and the copper particles (B). When the thermoplastic resin content is in this range, the thermoplastic resin (F) can act as a primer that assists adhesion between the metallic copper and a substrate and does not deteriorate the electrical conductivity of the conductive film formed.

When the conductive film-forming composition includes the surfactant, the surfactant content in the conductive film-forming composition is not particularly limited. From the viewpoint of coating quality improvement, the surfactant content is preferably from 0.0001 to 1 wt% and more preferably from 0.001 to 0.1 wt%.

The viscosity of the conductive film-forming composition is preferably adjusted to the viscosity suitable for printing such as ink jet printing, screen printing and the like. When the conductive film-forming composition is discharged for ink jet printing, the viscosity of the conductive film-forming composition is preferably from 1 to 50 cP and more preferably from 1 to 40 cP. When the conductive film-forming composition is used for screen printing, the viscosity of the conductive film-forming composition is preferably from 1000 to 100,000 cP and more preferably from 10,000 to 80,000 cP.

A preparation method of the conductive film-forming composition is not particularly limited, and any conventional method can be used. For example, after the copper oxide particles (A) and the polyol compound (C) are added to the solvent, the ingredients are dispersed by a known method such as an ultrasonic method (e.g. treatment by an ultrasonic homogenizer), a mixer method, a three roll method, and a ball mill method, whereby a dispersion solution of the copper oxide particles (A) is obtained. Subsequently, after the copper particles (B) are added to the resulting dispersion solution, the ingredients are dispersed by a known method such as the ultrasonic method (e.g. treatment by an ultrasonic homogenizer), the mixer method, the three roll method, and the ball mill method, whereby the conductive film-forming composition can be obtained.

### [Manufacturing method of conductive film]

The manufacturing method of the conductive film of the invention includes a step of forming a coating film (referred to as "coating film formation step" hereinafter), in which the conductive film-forming composition described above is applied on a substrate, and a step of forming a conductive film (referred to as "conductive film formation step" hereinafter), in which heating and firing treatment is performed on the coating film using heat or light as a heat source. Optionally, the manufacturing method of the conductive film of the invention further includes a drying step, in which the coating film is dried after the coating film formation step and before the conductive film formation step. The procedures of these steps will be described in detail below.

### (Coating film formation step)

This step is a step in which the conductive film-forming composition described above is applied on a substrate to form a coating film. A precursor film prior to the reduction treatment is obtained by the step.

As a substrate used in the step, any known substrate can be used. Examples of a material used as a substrate include resin, paper, glass, silicon-based semiconductors, compound semiconductors, metallic oxides, metallic nitrides, wood, and composites thereof.

More specifically, examples include: resin substrates such as low density polyethylene resin, high density polyethylene resin, ABS resin, acrylic resin, styrene resin, vinyl chloride resin, polyester resin (polyethylene terephthalate (PET)), polyacetal resin, polysulphone resin, polyetherimide resin, polyetherketone resin, polyimide resin, and cellulose derivative; paper substrates such as uncoated printing paper, ultralight weight coated printing paper, coated printing paper (art paper, coated paper), special printing paper, copy paper (PPC paper), unbleached wrapping paper (unglazed shipping sacks kraft paper, unglazed kraft paper), bleached wrapping paper (bleached kraft paper, machine glazed poster paper), coated board, chipboard, and corrugated cardboard; glass substrates such as soda-lime glass, borosilicate glass, silica glass, and quartz glass; silicon-based semiconductor substrates such as amorphous silicon, and polysilicon; compound semiconductor substrates such as CdS, CdTe, and GaAs; metal substrates such as copper plates, iron plates and aluminum plates; other inorganic substrates such as alumina, sapphire, zirconia, titania, yttrium oxide, indium oxide, indium tin oxide (ITO), indium zinc oxide (IZO), tin oxide (NESA), antimony-doped tin oxide (ATO), fluoride-doped tin oxide, zinc oxide, aluminum-doped zinc oxide (AZO), gallium-doped zinc oxide, aluminum nitride substrate, and silicon carbide; composite substrates such as paper-resin composites exemplified by paper-phenolic resin, paper-epoxy resin, and paper-polyester resin, and glass-resin composites exemplified by glass cloth-epoxy resin (glass epoxy resin), glass cloth-polyimide-based resin, and glass cloth-fluororesin. Among these, polyester resin substrates, polyetherimide resin substrates, paper substrates and glass substrates are preferably used.

A method of applying the conductive film-forming composition on the substrate is not particularly limited, and any conventional method can be used. Examples include coating methods such as a screen printing method, a dip coating method, a spray coating method, a spin coating method and an ink jet method.

A shape of coating is not particularly limited, and can be a planer shape covering the whole surface of the substrate or in forms of patterns (e.g. in forms of interconnects or dots).

An amount of the coating of the conductive film-forming composition on the substrate can be appropriately adjusted according to a desired conductive film thickness, and generally the thickness of the coating film is preferably from 0.1 to 100 µm, more preferably from 1 to 50 µm, even more preferably from 5 to 30 µm, further more preferably from 7 to 20 µm and even further more preferably from 10 to 20 µm.

### (Drying step)

This step is a step in which the coating film formed is subjected to drying treatment to remove the solvent. The present step may be performed after the coating film formation step described above and before the conductive film formation step described below, as desired.

Removal of the residual solvent can suppress development of fine cracks or gaps caused by vaporization and expansion of the solvent in the conductive film formation step and is preferable from the viewpoint of electrical conductivity of the conductive film and adhesion of the same with the substrate.

As a method of drying treatment, a hot air drier or the like can be used. The temperature in heating treatment is preferably from 40 to 200°C, more preferably not less than 50°C but less than 150°C, and even more preferably from 70 to 120°C. When the metallic copper particles are used, a condition that suppresses the oxidation is preferable. The drying treatment in an inert gas atmosphere, such as nitrogen or argon for example, is preferable, and the drying treatment under a reducing gas atmosphere, such as hydrogen, is more preferable.

### (Conductive film formation step)

This step is a step in which the coating film formed is subjected to heating and firing treatment using heat or light as a heat source, and the conductive film containing metallic copper is formed.

By performing heating and firing treatment using heat or light as a heat source, copper oxide in the copper oxide particles A is reduced to metallic copper, and further sintered, thereby obtaining metallic copper.

By performing the treatment described above, metallic copper particles obtained by reduction of the copper oxide particles (A), and furthermore, the metallic copper particles and the copper particles (B) are fused together to form grains, and furthermore the grains are bonded and fused together to form a copper film.

If light irradiation treatment is performed, presumably, the copper oxide particles (A) or the copper particles (B) act as a photothermal conversion substance that absorbs light to convert it to heat and play a role of transferring heat into the coating film.

The optimum condition of the heating treatment is appropriately selected according to the kind of the polyol compound (C) and the solvent. From the viewpoint of forming the conductive film with excellent electrical conductivity in a short time, the heating temperature is preferably from 100 to 300°C, and more preferably from 150 to 250°C, while the heating time is preferably from 5 to 120 minutes, and more preferably from 10 to 60 minutes.

The means of heating is not particularly limited and any known method of heating such as an oven and a hot plate can be used.

The invention has an advantage in that the conductive film can be formed through the heating treatment at a relatively low temperature, resulting in the low processing cost.

The light irradiation treatment enables reduction to and sintering of metallic copper by irradiating with light a portion where the coating film is applied, at a room temperature for a short time. By the light irradiation treatment, degradation of the substrate due to exposure to heat for a long time can be avoided and adhesion between the conductive film and the substrate is improved.

The light source used in light irradiation treatment is not particularly limited, and may be, for example, a mercury lamp, a metal halide lamp, a xenon lamp, a chemical lamp, a carbon arc lamp, or the like. The radiation may be electron rays, X-rays, ion beams, far infrared rays, or the like. Also, g-line rays, i-line rays, deep UV rays, or high-density energy beams (laser beams) can be used.

Examples of specific embodiments include scanning exposure by an infrared laser, high-intensity flash exposure using a xenon discharge lamp and the like, exposure with an infrared lamp, and the like.

The light irradiation is preferably light irradiation by a flash lamp, and more preferably pulsed light irradiation by a flash lamp. The irradiation with high-energy pulsed light can intensively heat the surface of the portion where the coating film is applied, in an exceptionally short time, and therefore the heat effect on the substrate can be minimized greatly.

The pulsed light irradiation energy is preferably from 1 to 100 J/cm², more preferably from 1 to 30 J/cm², and the pulse width is preferably from 1 µs to 100 ms, and more preferably from 10 µs to 10 ms. The irradiation time of the pulsed light is preferably from 1 to 100 ms and more preferably from 1 to 50 ms and even more preferably from 1 to 20 ms.

The heating treatment and the light irradiation treatment described above can be performed alone or in combination simultaneously. Or after one of the treatments is performed, the other treatment can be further performed.

The atmosphere in which the heating treatment or the light irradiation treatment described above is performed is not particularly limited, and examples thereof include an air atmosphere, an inert atmosphere, a reducing atmosphere and the like. The inert atmosphere is an atmosphere that is filled with an inert gas such as, for example, argon, helium, neon, nitrogen and the like and the reducing atmosphere is an atmosphere in which a reducing gas such as hydrogen, carbon monoxide and the like is present.

### (Conductive film)

By performing the steps described above, the conductive film (copper film) containing metallic copper is obtained.

The thickness of the conductive film is not particularly limited, and is appropriately adjusted to a suitable thickness according to intended use. In particular, for use in a printed circuit board, the thickness of the conductive film is preferably from 0.01 to 1000 µm, and more preferably from 0.1 to 100 µm.

The film thickness is a value of arithmetic average (average value) of measurements obtained by measuring the thickness at any three or more points of the conductive film.

From the viewpoint of electrical conductivity characteristics, the volume resistivity of the conductive film is less than 300 µΩ·cm, preferably less than 100 µΩ·cm, and more preferably less than 50 µΩ·cm.

The volume resistivity can be calculated by measuring the surface resistivity of the conductive film by a four point probe method and then multiplying the obtained surface resistivity by the film thickness.

Adhesion of the conductive film to a substrate can be evaluated by, for example, visual observation of conductive film appearance after adhering a piece of cellophane tape to the conductive film, bringing them into a tight contact, and peeling the cellophane tape off from the conductive film. In the case of this method, the peeled area at the interface between the conductive film and the substrate is less than 5%. Preferably, there is no peeling observed at the interface between the conductive film and the substrate. More preferably, peeling is not observed at the interface between the conductive film and the substrate and in addition, adhesion of the conductive film is not observed on the cellophane tape.

The conductive film may be provided on the whole surface of the substrate or in a pattern shape. A patterned conductive film is suitably used as a conductive interconnect (interconnects) of a printed circuit board.

Example methods to obtain a patterned conductive film include a method in which the conductive film-forming composition described above is provided on the substrate in a pattern shape and subjected to the heating treatment and/or the light irradiation treatment described above, and a method in which the conductive film provided on the whole surface of the substrate is subjected to etching to form a pattern.

The etching method is not particularly limited and a known method such as a subtractive or a semi-additive method can be used.

When the patterned conductive film is configured to be a multilayer circuit board, an insulating layer (insulating resin layer, inter-layer insulating film, solder resist) may be further formed on the surface of the patterned conductive film, and further interconnects (a metal pattern) may be formed on the surface thereof.

The insulating film material is not particularly limited, and examples thereof include epoxy resin, glass epoxy resin, aramid resin, crystalline polyolefin resin, amorphous polyolefin resin, fluorine-containing resins (polytetrafluoroethylene, perfluorinated polyimide, perfluorinated amorphous resin and the like), polyimide resin, polyethersulfone resin, polyphenylene sulfide resin, polyether ether ketone resin, liquid crystal resin and the like.

Among these, from the viewpoints of adhesion, dimension stability, heat resistance, and electrical insulating properties, the insulating film material preferably contains epoxy resin, polyimide resin or liquid crystal resin, and more preferably contains epoxy resin. Specifically, ABF GX-13 manufactured by Ajinomoto Fine-Techno Co. Inc. and the like can be used.

Meanwhile, examples of the solder resist, which is one kind of insulating layer materials used for interconnects protection, are described in detail in JP 10-204150 A, JP 2003-222993 A and the like, and the materials described therein may be used in the invention as desired. Commercial products may be used for the solder resist, and specific examples thereof include PFR800 and PSR4000 (trade names) manufactured by Taiyo Ink Mfg Co., Ltd. and SR7200G manufactured by Hitachi Chemical Company, Ltd. and the like.

The substrate having the conductive film (the substrate with the conductive film) obtained as described above can be used for various applications. Examples of the applications include a printed circuit board, TFT, FPC, RFID and the like. Examples

### [Preparation of conductive film-forming composition and production of conductive film]

### <Example 1>

### (Preparation of conductive ink composition)

Copper oxide particles 1 (NanoTek^{(R)} CuO, manufactured by C. I. Kasei Co., Ltd.) (45 parts by weight), polyol compound 1 (polyethylene oxide, weight-average molecular weight: 400) (8 parts by weight), thixotropic agent 1 (BYK 425, manufactured by BYK Japan KK) (2 parts by weight), water (10 parts by weight) and ethanol (20 parts by weight) were mixed, and the mixture was stirred for 5 minutes using a planetary centrifugal mixer (THINKY MIXER ARE-310, manufactured by Thinky Corporation) to produce a dispersion solution of the copper oxide particles 1. The average particle size of the copper oxide particles 1 was 110 nm. Copper particles 1 (wet copper powder 1020Y, manufactured by Mitsui Mining and Smelting Co., Ltd., average particle size: 360 nm) (45 parts by weight) were added to the dispersion solution, and the dispersion solution was stirred by the planetary centrifugal mixer (described above) for 5 minutes to produce a conductive film-forming composition. The conductive film-forming composition is called "conductive ink composition 1". The conductive film-forming composition is sometimes called the conductive ink composition hereinafter.

### (Production of conductive film)

The conductive ink composition 1 prepared was coated in a striped pattern (L/S = 1 mm/1 mm) on a polyimide substrate (Kapton^{(R)} 200H, manufactured by Toray Industries, Inc.), and then dried for 10 minutes at 100°C. Thus, a coating film, on which an ink layer was pattern-printed, was obtained.

Thereafter, the coating film was heated to 400°C at a temperature increase rate of 50°C/min, kept at the temperature for 10 minutes, and then cooled down to 100°C by RTA firing apparatus AccuThermo 410 (manufactured by Allwin21 Corp.). The sample was taken out and a conductive film was obtained.

### <Example 2>

Except that copper particles 2 (wet copper powder 1030Y manufactured by Mitsui Mining and Smelting Co., Ltd., average particle size: 480 nm) was used instead of the copper particles 1 (average particle size: 360 nm), a conductive ink composition 2 was prepared in the same manner as in Example 1, and a conductive film was formed on the substrate.

### <Example 3>

Except that copper particles 3 (wet copper powder 1050Y manufactured by Mitsui Mining and Smelting Co., Ltd., average particle size: 750 nm) was used instead of the copper particles 1 (average particle size: 360 nm), the conductive ink composition 3 was prepared in the same manner as in Example 1, and a conductive film was formed on the substrate.

### <Example 4>

### (Synthesis of copper particles)

Copper(II) acetate hydrate (115 g) was dissolved with distilled water (1700 g) and formic acid (30 g) in a glass container to prepare an aqueous solution containing copper ion. The prepared aqueous solution had a pH of 2.5. The aqueous solution was heated under stirring to 40°C and 50 wt% aqueous hypophosphorous acid solution (180 g) was added. The color of the aqueous solution changed from blue to green and finally to brown in 5 minutes after the addition. The solution was continuously stirred for 30 minutes at 40°C, and subsequently the particles were identified by X-ray diffraction. The particles were confirmed to be hydrogenated copper particles. The solution obtained was further heated at 80°C for 60 minutes, so that the hydrogenated copper was decomposed, whereby a metallic copper particle dispersion was obtained. The average particle size of the metallic copper fine particles deposited on the particle surface was confirmed to be 200 nm. Collection of the particles by a centrifuge and re-dispersion of the particles into water were repeated three times, and the particles were separated and collected by a centrifuge and dried to obtain powder.

### (Preparation of conductive ink composition and production of conductive film)

Except that copper particles (average particle size: 200 nm) synthesized as above was used instead of the copper particles 1 (average particle size: 360 nm), a conductive ink composition 4 was prepared in the same manner as in Example 1, and a conductive film was formed on the substrate.

### <Example 5>

Except that copper particles 5 (wet copper powder 1100Y manufactured by Mitsui Mining and Smelting Co., Ltd., average particle size: 1000 nm) was used instead of the copper particles 1 (average particle size: 360 nm), a conductive ink composition 5 was prepared in the same manner as in Example 1, and a conductive film was formed on the substrate.

### <Example 6>

Except that the mixture was subjected to stirring by a planetary centrifugal mixer for 10 minutes, a dispersion solution of copper oxide particles was obtained in the same manner as in Example 1. The average particle size of the copper oxide particles obtained was 80 nm. Except that the dispersion solution of the copper oxide particles was used instead of the dispersion solution of the copper oxide 1, a conductive ink composition 6 was prepared in the same manner as in Example 1, and a conductive film was formed on the substrate.

### <Example 7>

Except that the mixture was subjected to stirring by a planetary centrifugal mixer for 4 minutes, a dispersion solution of copper oxide particles was obtained in the same manner as in Example 1. The average particle size of the copper oxide particles obtained was 180 nm. Except that the dispersion solution of the copper oxide particles was used instead of the dispersion solution of the copper oxide 1, a conductive ink composition 7 was prepared in the same manner as in Example 1, and a conductive film was formed on the substrate.

### <Example 8>

Except that the mixture was subjected to stirring by a planetary centrifugal mixer for 2 minutes, a dispersion solution of copper oxide particles was obtained in the same manner as in Example 1. The average particle size of the copper oxide particles obtained was 320 nm. Except that the dispersion solution of the copper oxide particles was used instead of the dispersion solution of the copper oxide 1, a conductive ink composition 8 was prepared in the same manner as in Example 1, and a conductive film was formed on the substrate.

### <Example 9>

Except that the mixture was stirred in a mortar for 1 minute instead of stirring by a planetary centrifugal mixer, a dispersion solution of copper oxide particles was obtained in the same manner as in Example 1. The average particle size of the copper oxide particles obtained was 480 nm. Except that the dispersion solution of the copper oxide particles was used instead of the dispersion solution of the copper oxide 1, a conductive ink composition 9 was prepared in the same manner as in Example 1, and a conductive film was formed on the substrate.

### <Example 10>

Except that the additive amount of the copper oxide particles 1 (average particle size: 110 nm) was changed from 45 parts by weight to 60 parts by weight, the additive amount of the copper particles 1 (average particle size: 360 nm) was changed from 45 parts by weight to 30 parts by weight, and the ratio between the total weight W_{A} of the copper oxide particles and the total weight W_{B} of the copper particles was set as W_{A}:W_{B} = 2:1, a conductive ink composition 10 was prepared in the same manner as in Example 1, and a conductive film was formed on the substrate.

### <Example 11>

Except that the additive amount of the copper oxide particles 1 (average particle size: 110 nm) was changed from 45 parts by weight to 67.5 parts by weight, the additive amount of the copper particles 1 (average particle size: 360 nm) was changed from 45 parts by weight to 22.5 parts by weight, and the ratio between the total weight W_{A} of the copper oxide particles and the total weight W_{B} of the copper particles was set as W_{A}:W_{B} = 3:1, a conductive ink composition 11 was prepared in the same manner as in Example 1, and a conductive film was formed on the substrate.

### <Example 12>

Except that the additive amount of the copper oxide particles 1 (average particle size: 110 nm) was changed from 45 parts by weight to 30 parts by weight, the additive amount of the copper particles 1 (average particle size: 360 nm) was changed from 45 parts by weight to 60 parts by weight, and the ratio between the total weight W_{A} of the copper oxide particles and the total weight W_{B} of the copper particles was set as W_{A}:W_{B} = 1:2, a conductive ink composition 12 was prepared in the same manner as in Example 1, and a conductive film was formed on the substrate.

### <Example 13>

Except that the additive amount of the copper oxide particles 1 (average particle size: 110 nm) was changed from 45 parts by weight to 25.7 parts by weight, the additive amount of the copper particles 1 (average particle size: 360 nm) was changed from 45 parts by weight to 64.3 parts by weight, and the ratio between the total weight W_{A} of the copper oxide particles and the total weight W_{B} of the copper particles was set as W_{A}:W_{B} = 1:2.5, a conductive ink composition 13 was prepared in the same manner as in Example 1, and a conductive film was formed on the substrate.

### <Example 14>

Except that the additive amount of the copper oxide particles 1 (average particle size: 110 nm) was changed from 45 parts by weight to 22.5 parts by weight, the additive amount of the copper particles 1 (average particle size: 360 nm) was changed from 45 parts by weight to 67.5 parts by weight, and the ratio between the total weight W_{A} of the copper oxide particles and the total weight W_{B} of the copper particles was set as W_{A}:W_{B} = 1:3, a conductive ink composition 14 was prepared in the same manner as in Example 1, and a conductive film was formed on the substrate.

### <Example 15>

Except that the additive amount of the polyol compound 1 (polyethylene oxide, weight-average molecular weight: 400) was changed from 8 parts by weight to 45 parts by weight, and the ratio between the total weight W_{AB} of the copper oxide particles and the copper particles and the total weight W_{C} of the polyol compound was set as W_{AB}:W_{C} = 2:1, a conductive ink composition 15 was prepared in the same manner as in Example 1, and a conductive film was formed on the substrate.

### <Example 16>

Except that the additive amount of the polyol compound 1 (polyethylene oxide, weight-average molecular weight: 400) was changed from 8 parts by weight to 18 parts by weight, and the ratio between the total weight W_{AB} of the copper oxide particles and the copper particles and the total weight W_{C} of the polyol compound was set as W_{AB}:W_{C} = 5:1, a conductive ink composition 16 was prepared in the same manner as in Example 1, and a conductive film was formed on the substrate.

### <Example 17>

Except that the additive amount of the polyol compound 1 (polyethylene oxide, weight-average molecular weight: 400) was changed from 8 parts by weight to 10 parts by weight, and the ratio between the total weight W_{AB} of the copper oxide particles and the copper particles and the total weight W_{C} of the polyol compound was set as W_{AB}:W_{C} = 9:1, a conductive ink composition 17 was prepared in the same manner as in Example 1, and a conductive film was formed on the substrate.

### <Example 18>

Except that the additive amount of the polyol compound 1 (polyethylene oxide, weight-average molecular weight: 400) was changed from 8 parts by weight to 6 parts by weight, and the ratio between the total weight W_{AB} of the copper oxide particles and the copper particles and the total weight W_{C} of the polyol compound was set as W_{AB}:W_{C} = 15:1, a conductive ink composition 18 was prepared in the same manner as in Example 1, and a conductive film was formed on the substrate.

### <Example 19>

Except that the additive amount of the polyol compound 1 (polyethylene oxide, weight-average molecular weight: 400) was changed from 8 parts by weight to 4.5 parts by weight, and the ratio between the total weight W_{AB} of the copper oxide particles and the copper particles and the total weight W_{C} of the polyol compound was set as W_{AB}:W_{C} = 20:1, a conductive ink composition 19 was prepared in the same manner as in Example 1, and a conductive film was formed on the substrate.

### <Example 20>

Except that a polyol compound 2 (pentaerythritol: refer to the formula below) (8 parts by weight) was added instead of the polyol compound 1 (polyethylene oxide, weight-average molecular weight: 400) (8 parts by weight), a conductive ink composition 20 was prepared in the same manner as in Example 1, and a conductive film was formed on the substrate.

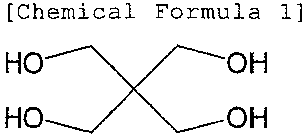

### <Example 21>

Except that a polyol compound 3 (polypropylene glycol, weight-average molecular weight: 700) (8 parts by weight) was added instead of the polyol compound 1 (polyethylene oxide, weight-average molecular weight: 400) (8 parts by weight), a conductive ink composition 21 was prepared in the same manner as in Example 1, and a conductive film was formed on the substrate.

### <Example 22>

Except that thermoplastic resin 1 (polyvinylpyrrolidone, weight-average molecular weight: 15,000) (2 parts by weight) was added instead of the thixotropic agent 1 (BYK 425, manufactured by BYK Japan KK) (2 parts by weight), a conductive ink composition 22 was prepared in the same manner as in Example 1, and a conductive film was formed on the substrate.

### <Example 23>

Except that copper particles 5 (wet copper powder 1100Y manufactured by Mitsui Mining and Smelting Co., Ltd., average particle size: 1000 nm) was used instead of the copper particles 1 (average particle size : 360 nm), and that the polyol compound 1 (polyethylene oxide, weight-average molecular weight: 400) (6 parts by weight) and the polyol compound 2 (pentaerythritol) (2 parts by weight) were added instead of the polyol compound 1 (polyethylene oxide, weight-average molecular weight: 400) (8 parts by weight), a conductive ink composition 23 was prepared in the same manner as in Example 1, and a conductive film was formed on the substrate.

### <Comparative Example 1>

Except that the additive amount of the copper oxide particles 1 was changed from 45 parts by weight to 90 parts by weight, and that no copper particles 1 were added, a conductive ink composition C1 was prepared in the same manner as in Example 1, and a conductive film was formed on the substrate.

### <Comparative Example 2>

Except that the additive amount of the copper particles 1 was changed from 45 parts by weight to 90 parts by weight, and that no copper oxide particles 1 were added, a conductive ink composition C2 was prepared in the same manner as in Example 1, and a conductive film was formed on the substrate.

### <Comparative Example 3>

Except that thermoplastic resin 1 (polyvinylpyrrolidone, weight-average molecular weight: 15,000) (8 parts by weight) was added instead of the polyol compound 1 (polyethylene oxide, weight-average molecular weight: 400) (8 parts by weight), a conductive ink composition C3 was prepared in the same manner as in Example 1, and a conductive film was formed on the substrate.

### <Comparative Example 4>

Except that the additive amount of the copper oxide particles 1 (average particle size: 110 nm) was changed from 45 parts by weight to 10 parts by weight, the additive amount of the copper particles 1 (average particle size: 360 nm) was changed from 45 parts by weight to 80 parts by weight, and the ratio between the total weight W_{A} of the copper oxide particles and the total weight W_{B} of the copper particles was set as W_{A}:W_{B} = 1:8, a conductive ink composition C4 was prepared in the same manner as in Example 1, and a conductive film was formed on the substrate.

### <Comparative Example 5>

Except that the additive amount of the copper oxide particles 1 (average particle size: 110 nm) was changed from 45 parts by weight to 80 parts by weight, the additive amount of the copper particles 1 (average particle size: 360 nm) was changed from 45 parts by weight to 10 parts by weight, and the ratio between the total weight W_{A} of the copper oxide particles and the total weight W_{B} of the copper particles was set as W_{A}:W_{B} = 8:1, a conductive ink composition C5 was prepared in the same manner as in Example 1, and a conductive film was formed on the substrate.

### <Comparative Example 6>

Except that the additive amount of the polyol compound 1 (polyethylene oxide, weight-average molecular weight: 400) was changed from 8 parts by weight to 90 parts by weight, and the ratio between the total weight W_{AB} of the copper oxide particles and the copper particles and the total weight W_{C} of the polyol compound was set as W_{AB}:W_{C} = 1:1, a conductive ink composition C6 was prepared in the same manner as in Example 1, and a conductive film was formed on the substrate.

### <Comparative Example 7>

Except that the additive amount of the polyol compound 1 (polyethylene oxide, weight-average molecular weight: 400) was changed from 8 parts by weight to 3 parts by weight, and the ratio between the total weight W_{AB} of the copper oxide particles and the copper particles and the total weight W_{C} of the polyol compound was set as W_{AB}:W_{C} = 30:1, a conductive ink composition C7 was prepared in the same manner as in Example 1, and a conductive film was formed on the substrate.

In Table 1, the average particle sizes and the additive amounts of the copper oxide particles (A) and the copper particles (B) in the conductive ink compositions, W_{A}:W_{B}, the kinds and the additive amounts of the polyol compound (C), W_{AB}:W_{C}, and electrical conductivity and adhesion of the conductive films obtained in Examples 1 to 23 and Comparative Examples 1 to 7 are listed. In the table, the additive amount of each ingredient is shown in terms of parts by weight of each ingredient per 100 parts by weight of ingredients in total (solids content) except a solvent.

### [Performance evaluation of conductive films]

### <Adhesion>

The conductive films obtained in Examples 1 to 23 and Comparative Examples 1 to 7 were evaluated for adhesion by the following method.

A cellophane tape (manufactured by Nichiban Co., Ltd., width: 24 mm) was adhered to each conductive film obtained to achieve a tight contact, then was removed. The appearance of each conductive film after the removal of the cellophane tape was visually observed and adhesion was evaluated. Evaluation criteria is as follows. The results of the evaluation were listed in Table 1. From a practical standpoint, A to C are preferred.
A: No adhesion of the conductive film was observed on the cellophane tape and no peeling was observed at the interface between the conductive film and the substrate.
B: Adhesion of the conductive film was slightly observed on the cellophane tape but no peeling was observed at the interface between the conductive film and the substrate.
C: Adhesion of the conductive film was distinctively observed on the cellophane tape and the peeled area of less than 5% was observed at the interface between the conductive film and the substrate.
D: Adhesion of the conductive film was distinctively observed on the cellophane tape and the peeled area of not less than 5% but less than 50% was observed at the interface between the conductive film and the substrate.
E: Adhesion of the conductive film was distinctively observed on the cellophane tape and the peeled area of not less than 50% was observed at the interface between the conductive film and the substrate.

### <Electrical conductivity>

The conductive films obtained in Examples 1 to 23 and Comparative Examples 1 to 7 were evaluated for electrical conductivity by the following method.

For each conductive film obtained, the volume resistivity was measured using a four point probe-method resistivity meter and the electrical conductivity was evaluated. Evaluation criteria is as follows. The results of the evaluation were listed in Table 1.
A: Volume resistivity was less than 50 µΩ·cm.
B: Volume resistivity was not less than 50 µΩ·cm but less than 100 µΩ·cm.
C: Volume resistivity was not less than 100 µΩ·cm but less than 300 µΩ·cm.
D: Volume resistivity was not less than 300 µΩ·cm but less than 1000 µΩ·cm.
E: Volume resistivity was not less than 1000 µΩ·cm
[Table 1]

**Table 1**

| | | Copper Oxide Particles (A) | | Copper Particles (B) | | W_{A}:W_{B} | Polyol Compound (C) | | W_{AB}:W_{C} | Electrical Conductivity | Adhesion |
|---|---|---|---|---|---|---|---|---|---|---|---|
| | | Average Particle Size [nm] | Additive Amount [parts by weight] | Average Particle Size [nm] | Additive Amount [parts by weight] | | Type | Additive Amount [parts by weight] | | | |
| | 1 | 110 | 45 | 360 | 45 | 1 : 1 | PEO400 | 8 | 11.3 : 1 | A | A |
| | 2 | 110 | 45 | 480 | 45 | 1 : 1 | PEO400 | 8 | 11.3 : 1 | A | A |
| | 3 | 110 | 45 | 750 | 45 | 1 : 1 | PEO400 | 8 | 11.3 : 1 | A | B |
| | 4 | 110 | 45 | 200 | 45 | 1 : 1 | PEO400 | 8 | 11.3 : 1 | A | A |
| | 5 | 110 | 45 | 1000 | 45 | 1 : 1 | PEO400 | 8 | 11.3 : 1 | B | B |
| | 6 | 80 | 45 | 360 | 45 | 1 : 1 | PEO400 | 8 | 11.3 : 1 | A | A |
| | 7 | 180 | 45 | 360 | 45 | 1 : 1 | PEO400 | 8 | 11.3 : 1 | A | A |
| | 8 | 320 | 45 | 360 | 45 | 1 : 1 | PEO400 | 8 | 11.3 : 1 | B | B |
| | 9 | 480 | 45 | 360 | 45 | 1 : 1 | PEO400 | 8 | 11.3 : 1 | C | B |
| | 10 | 110 | 60 | 360 | 30 | 2 : 1 | PEO400 | 8 | 11.3 : 1 | A | B |
| | 11 | 110 | 67.5 | 360 | 22.5 | 3 : 1 | PEO400 | 8 | 11.3 : 1 | C | B |
| Example | 12 | 110 | 30 | 360 | 60 | 1 : 2 | PEO400 | 8 | 11.3 : 1 | A | A |
| | 13 | 110 | 25.7 | 360 | 64.3 | 1 : 2.5 | PEO400 | 8 | 11.3 : 1 | A | B |
| | 14 | 110 | 22.5 | 360 | 67.5 | 1 : 3 | PEO400 | 8 | 11.3 : 1 | B | B |
| | 15 | 110 | 45 | 360 | 45 | 1 : 1 | PEO400 | 45 | 2 : 1 | C | B |
| | 16 | 110 | 45 | 360 | 45 | 1 : 1 | PEO400 | 18 | 5 : 1 | B | B |
| | 17 | 110 | 45 | 360 | 45 | 1 : 1 | PEO400 | 10 | 9 : 1 | A | A |
| | 18 | 110 | 45 | 360 | 45 | 1 : 1 | PEO400 | 6 | 15 : 1 | A | A |
| | 19 | 110 | 45 | 360 | 45 | 1 : 1 | PEO400 | 4.5 | 20 : 1 | C | B |
| | 20 | 110 | 45 | 360 | 45 | 1 : 1 | PETP | 8 | 11.3 : 1 | A | A |
| | 21 | 110 | 45 | 360 | 45 | 1 : 1 | PPG700 | 8 | 11.3 : 1 | A | A |
| | 22 | 110 | 45 | 360 | 45 | 1 : 1 | PEO400 | 8 | 11.3 : 1 | A | A |
| | 23 | 110 | 45 | 1000 | 45 | 1 : 1 | PEO400 | 6 | 11.3 : 1 | B | B |
| | | | | | | | PETP | 2 | | | |
| Comparative Example | 1 | 110 | 90 | - | - | 1 : 0 | PEO400 | 8 | 11.3 : 1 | B | D |
| | 2 | - | - | 360 | 90 | 0 : 1 | PEO400 | 8 | 11.3 : 1 | D | D |
| | 3 | 110 | 45 | 360 | 45 | 1 : 1 | - | - | 11.3 : 0 | C | E |
| | 4 | 110 | 10 | 360 | 80 | 1 : 8 | PEO400 | 8 | 11.3 : 1 | C | D |
| | 5 | 110 | 80 | 360 | 10 | 8 : 1 | PEO400 | 8 | 11.3 : 1 | B | D |
| | 6 | 110 | 45 | 360 | 45 | 1 : 1 | PEO400 | 90 | 1 : 1 | D | E |
| | 7 | 110 | 45 | 360 | 45 | 1 : 1 | PEO400 | 3 | 30 : 1 | E | E |

In the Table 1, PEO400, PPG700 and PETP represent polyethylene oxide (weight-average molecular weight: 400), polypropyleneglycol (weight-average molecular weight: 700) and pentaerythritol, respectively.

The conductive film-forming compositions (conductive ink compositions) of Examples 1 to 23 and Comparative Examples 1 to 7 each contained water (10 parts by weight) and ethanol (20 parts by weight) as the solvent (D) in addition to the ingredients listed in Table 1. In each of Examples 1 to 21 and 23 and Comparative Examples 1 to 7, BYK425 (2 parts by weight) was further contained as the thixotropic agent (F), and polyvinylpyrrolidone was contained as the thermoplastic resin (E) in an amount of 2 parts by weight in Example 22 and in an amount of 8 parts by weight in Comparative Example 3.

Examples 1 to 23 and Comparative Examples 1 to 3 are compared below. In Examples 1 to 23, the evaluation results of electrical conductivity are C or better and the evaluation results of adhesion are B or better, and thus they are excellent. Meanwhile, in Comparative Examples 1 to 3 in which one among the ingredients of the copper particles (B), the copper oxide particles (A) and the polyol compound (C) was not included, the evaluation results of adhesion are either D or E, and these Comparative Examples do not fulfill the requirement for practical use. Furthermore, in Comparative Example 2 in which the copper oxide particles (A) were not included, the evaluation result of electrical conductivity is D and this Comparative Example does not fulfill the requirement for practical use.

Examples 1 and 10 to 14 and Comparative Examples 4 and 5 are compared below. In Examples 1 and 10 to 14 in which the ratio between the total weight W_{A} of the copper oxide particles (A) and the total weight W_{B} of the copper particles (B) (W_{A}:W_{B}) was in the range from 1:3 to 3:1, the evaluation results of electrical conductivity are C or better and the evaluation results of adhesion are B or better, and thus they are excellent. Meanwhile, in Comparative Examples 4 and 5 in which the ratio of W_{A}:W_{B} was outside the range, the evaluation results of electrical conductivity are B or C and the requirement for practical use is fulfilled, but the evaluation results of adhesion are D and the requirement for practical use is not fulfilled.

Examples 1 and 10 to 14 are compared below. When the ratio between the total weight W_{A} of the copper oxide particles (A) and the total weight W_{B} of the copper particles (B) (W_{A}:W_{B}) is within the range from 1:2.5 to 2:1, electrical conductivity is even better (Examples 1, 10, 12 to 14), and when the ratio is within the range from 1:2 to 1:1, adhesion is also even better (Examples 1 and 12).

Examples 1 and 15 to 20 and Comparative Examples 6 and 7 are compared below. In Examples 1 and 15 to 20 in which the ratio between the total weight W_{AB} of the copper oxide particles (A) and the copper particles (B) and the total weight W_{C} of the polyol compound (C) (W_{AB}:W_{C}) was within the range from 20:1 to 2:1, the evaluation results of electrical conductivity are C or better and the evaluation results of adhesion are B or better, and thus they are excellent. Meanwhile, in Comparative Examples 6 and 7 in which the ratio W_{AB}:W_{C} was outside the range, the evaluation results of electrical conductivity are D or E and the evaluation results of adhesion are E, and the requirements for practical use are not fulfilled in any factor.

Examples 1 and 15 to 19 are compared below. When the ratio between the total weight W_{AB} of the copper oxide particles (A) and the copper particles (B) and the total weight W_{C} of the polyol compound (C) (W_{AB}:W_{C}) is within the range from 5:1 to 15:1, electrical conductivity is even better (Examples 1, 16 to 18), and when the ratio is within the range from 9:1 to 15:1, adhesion is also even better (Examples 17, 18).

Examples 1 to 5 are compared below. In Examples 1, 2 and 4 in which the average particle size of the copper particles (B) was in the range of not less than 200 nm but less than 500 nm, electrical conductivity and adhesion are both rated A, and Examples 1, 2 and 4 are better in adhesion than Examples 3 and 5 in which the average particle size was not less than 500 nm.

Examples 1 and 6 to 9 are compared below. In Examples 1, 6 and 7 in which the average particle size of the copper oxide particles (A) was in the range from 50 to 300 nm, electrical conductivity and adhesion are both rated A, and Examples 1, 6 and 7 are better in both electrical conductivity and adhesion than Examples 8 and 9 in which the average particle size was more than 300 nm but not less than 500 nm.

## Claims

1. A conductive film-forming composition comprising: copper oxide particles (A) having an average particle size of from 10 to 500 nm; copper particles (B) having an average particle size of from 100 to 1000 nm; a polyol compound (C) having two or more hydroxy groups in a molecule thereof; and at least one kind of solvent (D) selected from the group consisting of water and a water-soluble solvent,
wherein a ratio between a total weight W_{A} of the copper oxide particles (A) and a total weight W_{B} of the copper particles (B), W_{A}:W_{B}, is in a range from 1:3 to 3:1, and
wherein a ratio between a total weight W_{AB} of the copper oxide particles (A) and the copper particles (B) and a total weight W_{C} of the polyol compound (C), W_{AB}:W_{C}, is in a range from 20:1 to 2:1.

2. The conductive film-forming composition according to claim 1, wherein the average particle size of the copper particles (B) is not less than 200 nm but less than 500 nm.

3. The conductive film-forming composition according to claim 1 or 2, wherein the ratio between the total weight W_{A} of the copper oxide particles (A) and the total weight W_{B} of the copper particles (B), W_{A}:W_{B}, is in a range from 1:2.5 to 2:1.

4. The conductive film-forming composition according to any one of claims 1 to 3, wherein the ratio between the total weight W_{A} of the copper oxide particles (A) and the total weight W_{B} of the copper particles (B), W_{A}:W_{B}, is in a range from 1:2 to 1:1.

5. The conductive film-forming composition according to any one of claims 1 to 4, further comprising a thixotropic agent (E).

6. The conductive film-forming composition according to any one of claims 1 to 5, further comprising a thermoplastic resin (F).

7. The conductive film-forming composition according to any one of claims 1 to 6, wherein the solvent (D) contains water.

8. The conductive film-forming composition according to any one of claims 1 to 7, wherein the average particle size of the copper oxide particles (A) is from 50 to 300 nm.

9. The conductive film-forming composition according to any one of claims 1 to 8, wherein the average particle size of the copper oxide particles (A) is from 80 to 180 nm.

10. The conductive film-forming composition according to any one of claims 1 to 9, wherein the copper oxide particles (A) are copper oxide particles composed of copper(II) oxide.

11. A conductive film manufacturing method, comprising:
a coating film formation step of forming a coating film by applying the conductive film-forming composition described in any one of claims 1 to 10 on a substrate, and
a conductive film formation step of forming a conductive film by heating and firing the coating film using heat or light as a heat source.

12. The conductive film manufacturing method according to claim 11, further comprising a drying step of drying the coating film after the coating film formation step and before the conductive film formation step.

13. The conductive film manufacturing method according to claim 11 or 12, wherein the substrate is a substrate made from polyimide resin or glass-epoxy resin.

14. The conductive film manufacturing method according to any one of claims 11 to 13, wherein a thickness of the coating film is from 1 to 9 µm.
